(19) Europäisches Patentamt
European Patent Office
Office européen des brevets

(11) **EP 2 405 465 A1**

(12) **DEMANDE DE BREVET EUROPEEN**

(43) Date de publication:
**11.01.2012 Bulletin 2012/02**

(51) Int Cl.:
***H01L 21/18*** *(2006.01)*

(21) Numéro de dépôt: **11168039.3**

(22) Date de dépôt: **30.05.2011**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **07.07.2010 FR 1055508**

(71) Demandeur: **S.O.I. Tec Silicon on Insulator Technologies**
**38190 Bernin (FR)**

(72) Inventeur: **Gweltaz, Gaudin**
**38000 Grenoble (FR)**

(74) Mandataire: **Desormiere, Pierre-Louis et al Cabinet Beau de Loménie**
**158, rue de l'Université**
**75340 Paris Cedex 07 (FR)**

(54) **Procédé de collage par adhésion moléculaire avec compensation de désalignement radial**

(57) Un procédé de collage par adhésion moléculaire d'une première plaque (100) sur une deuxième plaque (200), lesdites plaques présentant entre elles un désalignement radial initial. Le procédé comprend au moins une étape de mise en contact des deux plaques (100, 200) de manière à initier la propagation d'une onde de collage entre les deux plaques. Conformément à l'invention, on impose une courbure de collage prédéfinie ($K_B$) en fonction du désalignement radial initial à l'une au moins des deux plaques lors de l'étape de mise en contact.

FIG.5D

EP 2 405 465 A1

FIG.5E

**Description**

Domaine technique et art antérieur

La présente invention concerne le domaine des plaques ou structures semi-conducteurs multicouches (également dénommées "multilayer semiconductor wafers") réalisées suivant la technologie d'intégration tridimensionnelle (3D-integration) qui met en oeuvre le transfert sur une première plaque, dite substrat final, d'au moins une couche formée à partir d'une deuxième plaque, cette couche correspondant à la portion de la deuxième plaque dans laquelle on a formé des éléments, par exemple, une pluralité de microcomposants, d'autres éléments correspondants étant également formés dans la première plaque.

En raison notamment de la taille très réduite et du nombre important de microcomposants présents sur une même couche, chaque couche transférée, c'est-à-dire chaque plaque comportant la couche, doit être positionnée sur le substrat final (première plaque seule ou comportant déjà d'autres couches transférées) avec une grande précision afin de respecter un alignement très strict avec la couche sous-jacente. En outre, il peut être nécessaire de réaliser des traitements sur la couche après son transfert, par exemple pour former d'autres microcomposants, pour découvrir en surface des microcomposants, pour réaliser des interconnections, etc., ces traitements devant également être réalisés avec une grande précision vis-à-vis des composants présents dans la couche.

Le transfert d'une couche sur le substrat final implique un collage par adhésion moléculaire entre une première plaque et une deuxième plaque du type de celles décrites ci-avant, la deuxième plaque étant en général ensuite amincie. Lors du collage, les deux plaques sont mécaniquement alignées. Trois types de défauts d'alignement peuvent être constatés entre les deux plaques, à savoir les défauts d'alignement de type décalage (encore appelé "offset" ou "shift"), de type rotation et de type radial (également connu sous le nom de "run-out", erreur de magnification ou erreur de déformation).

Lorsqu'une séquence d'étape de lithographie est réalisée sur une seule plaque, ces types de défauts sont généralement corrigés en utilisant un algorithme de compensation dans la machine de lithographie afin de préserver un alignement parfait entre chaque étape.

Lors d'un alignement entre deux plaques en vue du collage, les défauts d'alignement de types décalage et rotation peuvent être compensés mécaniquement en modifiant la position relative des plaques entre elles dans la machine de collage. Cependant, les défauts d'alignement de type radial ne peuvent pas être compensés par un tel repositionnement des plaques.

Le désalignement radial se produit lorsque deux plaques à aligner présentent des dilatations radiales différentes, les dilatations radiales pouvant provenir du fait que chaque plaque a subi un procédé différent de fabrication de microcomposants et/ou du fait que les procédés appliqués sur l'une ou l'autre des plaques peuvent conduire à contraindre celles-ci et faire varier, à l'échelle microscopique, leurs dimensions comme dans le cas, par exemple, d'un dépôt de couche ou d'une oxydation qui induit des contraintes en tension sur la plaque.

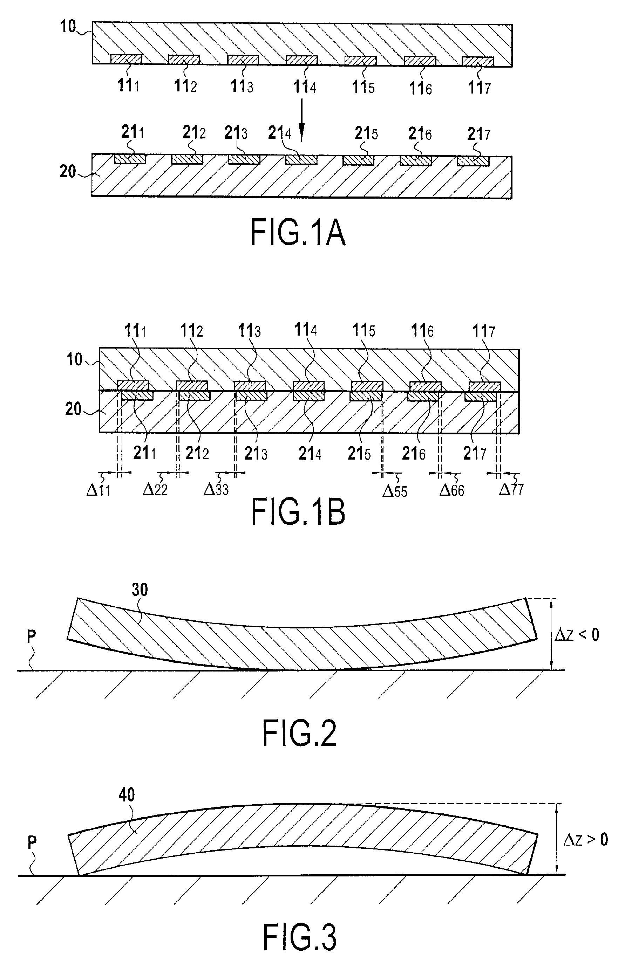

La figure 1A illustre l'alignement entre une première plaque 10 et une deuxième plaque 20 en vue de leur collage par adhésion moléculaire. Une première série de microcomposants 11 on été préalablement formés sur la face de collage de la première plaque 10 tandis qu'une deuxième série de microcomposants 21 ont été formés préalablement sur la face supérieure de la deuxième plaque 20 destinée à être collée avec la première plaque. Les microcomposants 11 sont destinés à être alignés avec les microcomposants 21 après collage des plaques.

Or, dans l'exemple décrit ici, les première et deuxième plaques présentent des dilatations radiales différentes créant ainsi un désalignement radial entre ces plaques qui se traduit, après collage, par des décalages entre la plupart des microcomposants tels que les décalages $\Delta_{11}$, $\Delta_{22}$, $\Delta_{33}$, $\Delta_{55}$, $\Delta_{66}$, ou $\Delta_{77}$ indiqués sur la figure 1B (correspondant respectivement aux décalages observés entre les couples de microcomposants $11_1/21_1$, $11_2/21_2$, $11_3/21_3$, $11_5/21_5$, $11_6/21_6$ et $11_7/21_7$).

Les dilatations radiales responsables du désalignement radial entre deux plaques sont généralement homogènes au niveau des plaques créant ainsi un désalignement radial qui évolue (i.e. s'accroit) de manière quasi linéaire entre le centre et la périphérie de la plaque.

Le désalignement radial peut être corrigé en particulier lors des étapes classiques de formation de microcomposants par photolithographie au moyen d'algorithme de corrections et en fonction de mesures de désalignement réalisées sur une plaque.

Cependant la correction du désalignement radial ne peut être réalisée que sur une plaque seule. En effet, lorsque la réalisation des microcomposants implique une étape de collage entre deux plaques, comme c'est le cas lors de la réalisation de structures tridimensionnelles, il n'est plus possible de réaliser des corrections en ce qui concerne le désalignement radial.

Par ailleurs, lorsqu'une couche de microcomposants est transférée sur un substrat final présentant une première couche de microcomposants, il est très important de pouvoir minimiser le désalignement radial entre les microcomposants de chacune des couches lorsque ceux-ci doivent être interconnectés entre eux. Il n'est en effet pas possible, dans ce cas, de compenser par la lithographie les désalignements existant entre les microcomposants des deux couches.

Résumé de l'invention

L'invention a pour but de proposer une solution qui permet de compenser le désalignement radial initial présent entre deux plaques destinées à être collées ensemble.

A cet effet, la présente invention propose un procédé de collage par adhésion moléculaire d'une première plaque sur une deuxième plaque, lesdites plaques présentant entre elles un désalignement radial initial, le procédé comprenant au moins une étape de mise en contact des deux plaques de manière à initier la propagation d'une onde de collage entre les deux plaques, caractérisé en ce qu'on impose une courbure de collage prédéfinie en fonction du désalignement radial initial à l'une au moins des deux plaques lors de l'étape de mise en contact.

Comme expliqué ci-après en détails, en contrôlant la courbure des plaques pendant leur collage, il est possible d'induire un désalignement radial supplémentaire qui va compenser le désalignement radial présent initialement.

Selon un aspect de l'invention, la deuxième plaque est libre de se conformer à la courbure de collage prédéfinie imposée à la première plaque lors de la propagation de l'onde de collage.

Selon un autre aspect de l'invention, les première et deuxième plaques sont des plaquettes de silicium ayant un diamètre de 300 mm et comportant chacune des microcomposants.

Selon un aspect de l'invention, le procédé comprend, avant le collage des plaques, les étapes suivantes :

- mesure du désalignement radial initial entre les deux plaques à compenser,
- mesure de la courbure de chaque plaque avant collage,
- détermination d'un désalignement radial de compensation du désalignement radial initial entre les deux plaques,
- calcul d'une courbure post collage apte à générer entre les deux plaques ledit désalignement radial de compensation,
- calcul de la courbure de collage prédéfinie en fonction de la courbure post collage calculée.

Selon un aspect particulier de l'invention, le procédé comprend les étapes suivantes:

- maintien de la première plaque et de la deuxième plaque en regard l'une de l'autre par respectivement un premier support de maintien et un second support de maintien, ledit premier support imposant à la première plaque ladite courbure de collage prédéfinie,
- mise en contact desdites plaques pour initier la propagation d'une onde de collage entre lesdites plaques,
- libération de la deuxième plaque du second support de maintien avant ou pendant la mise en contact avec la première plaque de manière à ce que ladite deuxième plaque se conforme à la courbure de collage imposée à la première plaque lors de la propagation de l'onde de collage.

Selon une caractéristique de l'invention, la courbure de collage prédéfinie est imposée à la première plaque par actionnement d'un vérin monté sur le premier support de maintien.

Selon une autre caractéristique de l'invention, la courbure de collage prédéfinie est imposée à la première plaque par une membrane interposée entre la première plaque et le premier support de maintien, ladite membrane présentant une courbure correspondant à ladite courbure de collage prédéfinie.

Selon encore une autre caractéristique de l'invention, la courbure de collage prédéfinie est imposée à la première plaque par le premier support de maintien, ledit premier support de maintien présentant une courbure correspondant à ladite courbure de collage prédéfinie.

Selon un aspect particulier de l'invention, les plaques comprennent chacune des microcomposants sur leur face de collage respective, au moins une partie des microcomposants d'une des plaques étant destinée à être alignée avec au moins une partie des microcomposants de l'autre plaque.

La présente invention a également pour objet un appareil de collage par adhésion moléculaire d'une première plaque sur une deuxième plaque, lesdites plaques présentant entre elles un désalignement radial initial, l'appareil comprenant des premier et second supports de maintien pour maintenir respectivement la première plaque et la deuxième plaque, appareil dans lequel, le premier support de maintien comprend des moyens pour imposer à la première plaque une courbure de collage prédéfinie en fonction du désalignement radial initial, l'appareil commandant le deuxième support pour libérer la deuxième plaque du second support de maintien après mise en contact avec la première plaque de manière à ce que ladite deuxième plaque se conforme à la courbure de collage imposée à la première plaque lors de la propagation d'une onde de collage.

Selon une caractéristique de l'invention, l'appareil de collage comprend des moyens de traitement pour calculer un rayon de courbure correspondant à la courbure de collage prédéfinie en fonction du désalignement radial initial ou un rayon de courbure correspondant à ladite courbure de collage prédéfinie en fonction du désalignement radial initial.

Selon une caractéristique de l'invention, le premier support de maintien comprend en outre un vérin apte à imposer la courbure de collage prédéfinie à la première plaque, le vérin étant piloté selon un rayon de courbure correspondant à ladite courbure de collage prédéfinie, l'appareil commandant le deuxième support pour libérer la deuxième plaque du second support de maintien avant ou pendant la mise en contact avec la première plaque de manière à ce que ladite deuxième plaque se conforme à la courbure de collage imposée à la première plaque lors de la propagation d'une onde de collage.

Selon une autre caractéristique de l'invention, l'appareil comprend en outre une membrane interposée entre la première plaque et le premier support de maintien, ladite membrane présentant une courbure correspondant à la courbure de collage prédéfinie.

Selon encore une autre caractéristique de l'invention, le premier support de maintien présente une courbure correspondant à la courbure de collage prédéfinie.

Selon un aspect de l'invention, les premier et deuxième supports de maintien comprennent des moyens de maintien des plaques par succion ou par force électrostatique.

Selon un autre aspect de l'invention, les premier et deuxième supports de maintien sont adaptés pour recevoir des substrats circulaires de 100 mm, 150 mm, 200 mm ou 300 mm de diamètre.

Brève description des figures

- les figures 1A et 1B, sont des vues schématiques montrant la réalisation d'une structure tridimensionnelle selon l'art antérieur,
- les figures 2 et 3 montrent des plaques présentant des déformations de type "bow",
- les figures 4A à 4C montrent les différentes courbures obtenues avant, pendant et après le collage de deux plaques par adhésion moléculaire,
- les figures 5A à 5G, sont des vues schématiques montrant la réalisation d'une structure tridimensionnelle mettant en oeuvre le procédé de collage par adhésion moléculaire de la présente invention,
- la figure 6 est un organigramme des étapes mises en oeuvre lors de la réalisation de la structure tridimensionnelle illustrée dans les figures 5A à 5G,
- la figure 7 est un graphique montrant l'évolution d'un désalignement radial final en fonction de la courbure imposée à deux plaques pendant leur collage par adhésion moléculaire.

Exposé détaillé de modes de réalisation de l'invention

La présente invention s'applique d'une manière générale au collage par adhésion moléculaire entre deux plaques qui présentent des dilatations radiales différentes entraînant un désalignement radial entre celles-ci après collage.

L'invention s'applique plus particulièrement mais non exclusivement au collage par adhésion moléculaire entre au moins deux plaques comprenant chacune des composants et dont au moins une partie des composants de chacune des plaques sont destinés à être alignés après collage.

Afin de compenser le phénomène de désalignement radial des plaques après collage, la présente invention propose d'imposer aux plaques lors de leur collage une courbure de collage qui a été définie préalablement en fonction du désalignement radial initial.

Plus précisément, avant collage, chacune des deux plaques présente une courbure propre qui peut être concave comme pour la plaque 30 de la figure 2 ou convexe comme pour la plaque 40 de la figure 3. Cette courbure détermine la déformation de courbure des plaques qui est désignée par le terme anglais "bow" dans la technologie de semi-conducteurs. Comme illustré sur les figures 2 et 3, le bow $\Delta z$ d'une plaque ou wafer correspond à la distance (flèche), généralement mesurée au niveau du centre de la plaque, entre un plan de référence P (typiquement parfaitement plat) sur lequel repose librement la plaque et la plaque elle-même. A l'échelle des diamètres de plaques habituellement utilisées dans le domaine des semi-conducteur, à savoir entre quelques dizaines de millimètres et 300 millimètres, le bow est mesurée en micromètres tandis que la courbure est généralement mesurée en $m^{-1}$ ou $km^{-1}$ car la courbure des plaques utilisées dans le domaine des semi-conducteurs est très faible et, par conséquent, le rayon de courbure correspondant très important.

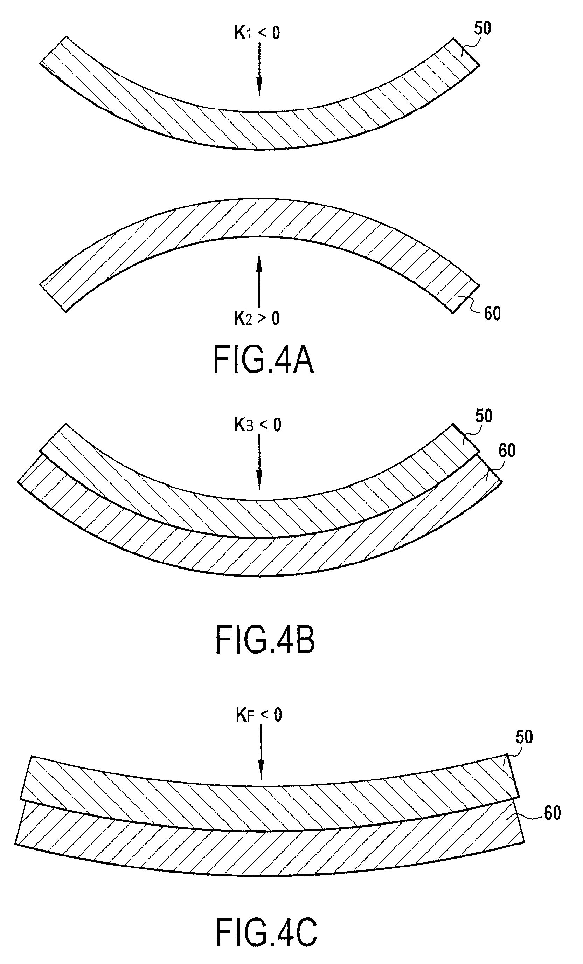

Les figures 4A à 4C montrent l'évolution des courbures avant et après collage d'une première plaque 50 (Top) sur une plaque support 60 (Base) présentant respectivement une courbure initiale $K_1$ et $K_2$ (figure 4A). Lors du collage par adhésion moléculaire, une courbure $K_B$, dite courbure de collage, est imposée à l'une des deux plaques 50 et 60 (figure 4B), l'autre plaque venant se conformer à la courbure imposée à cette première plaque lors de la propagation de l'onde de collage comme décrit en détails ci-après. La courbure $K_B$ peut être imposée par des supports de maintien spécifiques d'une machine de collage comme décrit ci-après en détails, la courbure $K_B$ étant à une seule des deux plaques tandis que l'autre plaque est libre de se déformer au moment de l'initiation de la propagation de l'onde de collage afin de conformer, lors de cette propagation, à la courbure imposée à l'autre plaque.

Une fois le collage réalisé et les plaques libérées de leur support de maintien respectifs, la structure constituée par l'assemblage des plaques collées 50 et 60 présent une courbure $K_F$, dite courbure post collage.

La courbure post collage $K_F$ peut être calculée avec la formule suivante:

$$K_F = (2(K_1 + K_2) + 12K_B)/16 \qquad (1)$$

Cette formule a été déterminée à partir de la formule (12) donnée dans le document T. Turner et al., intitulé "Mechanics of wafer bonding: Effect of clamping", Journal of Applied Physics, Vol. 95, N° 1, January 1, 2004.

A partir de cette formule, on constate que l'influence de la courbure de collage $K_B$ sur la courbure post collage $K_F$ est prédominante (d'un facteur 6) par rapport à celle des courbures initiales $K_1$ et $K_2$ respectivement des plaques 50 et 60.

Par ailleurs, le désalignement radial $D_R$ résultant entre les deux plaques après collage peut être déterminé par la formule suivante:

$$D_R = -2(\varepsilon R) \qquad (2)$$

où R est la distance du centre de la plaque au point de mesure du désalignement radial et $\varepsilon$ la contrainte exercée à la surface de la première plaque 50 (Top).

Il existe en outre une relation entre la contrainte exercée à la surface de la première plaque et la courbure post collage $K_F$ qui est donnée par la formule suivante:

$$\varepsilon = K_F (h/2) \qquad (3)$$

où h est l'épaisseur de la première plaque.

En introduisant dans la formule (2) les éléments de la formule (3) correspondant à la contrainte $\varepsilon$, on établit la relation entre le désalignement radial $D_R$ résultant après collage et la courbure post collage $K_F$ par la formule suivante:

$$D_R = -K_F \, h \, R \qquad (4)$$

On constate que le désalignement radial $D_R$ est fonction de la courbure post collage $K_F$.

Par conséquent, en connaissant le désalignement radial initial $D_{Ri}$, on détermine un désalignement radial de compensation $D_{Rc}$ tel que: $D_{Rc} = -D_{Ri}$, ce qui donne avec la formule (4): $D_{Rc} = K_F \, h \, R$

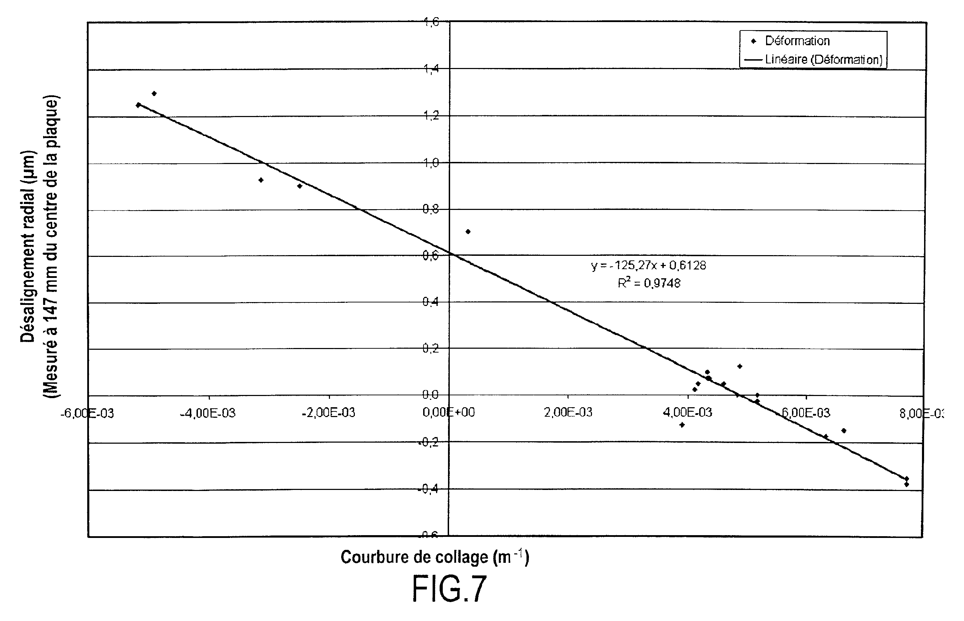

Le désalignement radial initial peut être mesuré en réalisant un collage sur entre deux plaques d'un même lot de plaques et en mesurant le désalignement des deux plaques pour en déduire la composante radiale initiale. Les deux plaques présentent des marques d'alignement, comme de simple croix (méthodes de mesure au moyen de structures Vernier ou Moiré) qui permettent de mesurer par microscopie infrarouge ou microscopie infrarouge confocale, le désalignement en microns, et ce en plusieurs endroits de la plaque qui sont généralement situés au centre et à la périphérie de celle-ci. Les différentes composantes de désalignement, et notamment le désalignement radial, peuvent être extraits de ces mesures. Ces mesures sont généralement réalisées au niveau de marques d'alignement disposées au centre et en périphérie de la plaque, par exemple à 147 mm du centre d'une plaque de 300mm. En périphérie, le désalignement radial est maximum et peut dépasser le micron, comme présenté en figure 7 ce qui est mesurable avec les technique de mesures microscopiques citées ci-avant.

De cette façon, on connaît le désalignement radial initial pour tout un lot de plaques auquel on peut appliquer le procédé de collage de l'invention et compenser le désalignement radial initial. La paire de plaque utilisée pour mesurer le désalignement radial initial peut être retirée du lot ou être séparée pour recoller les plaques avec la courbure de collage prédéterminée selon l'invention.

Ce désalignement radial initial pourrait être également déterminé en mesurant précisément la distance entre deux microcomposants (à 0.33 ppm près) sur chacune des deux plaques prises séparément et en comparant ces deux distances.

A partir de cette dernière formule (4), on calcule la courbure post collage cible $K_{Fc}$ permettant d'obtenir le désalignement radial de compensation suivant la formule:

$$K_{Fc} = D_{Rc}/(h.R) \quad (5)$$

La formule (1) montre que la courbure post collage $K_F$ est déterminée en fonction des courbures initiales $K_1$ et $K_2$ des deux plaques et de la courbure de collage $K_B$. Les courbures $K_1$ et $K_2$ correspondant aux courbures intrinsèques des deux plaques, seule la courbure $K_B$ représente le paramètre variable permettant d'ajuster la valeur de la courbure post collage $K_F$.

Ainsi, la valeur cible de la courbure post collage $K_{Fc}$ permettant d'obtenir le désalignement radial de compensation ayant été calculée à partir de la formule (5) et les courbures $K_1$ et $K_2$ ayant été mesurées préalablement, par exemple au moyen d'outils de mesure optique tels que KLA-Tencor Flexus de la société KLA-Tencor Corp (ou par toute mesure par jauge capacitive, profilométrie optique ou mécanique qui permet de déterminer le bow), on calcule la courbure de collage $K_B$ à imposer lors de celui-ci aux plaques pour obtenir la courbure post collage cible $K_{Fc}$ tel que:

$$K_B = (8K_{Fc} - (K_1+K_2))/6 \quad (6)$$

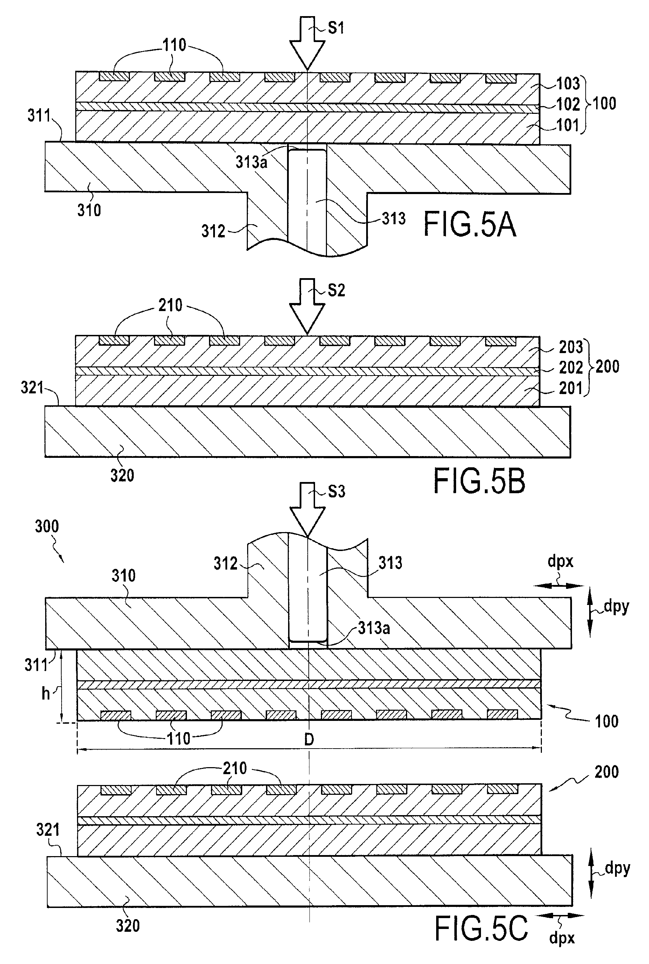

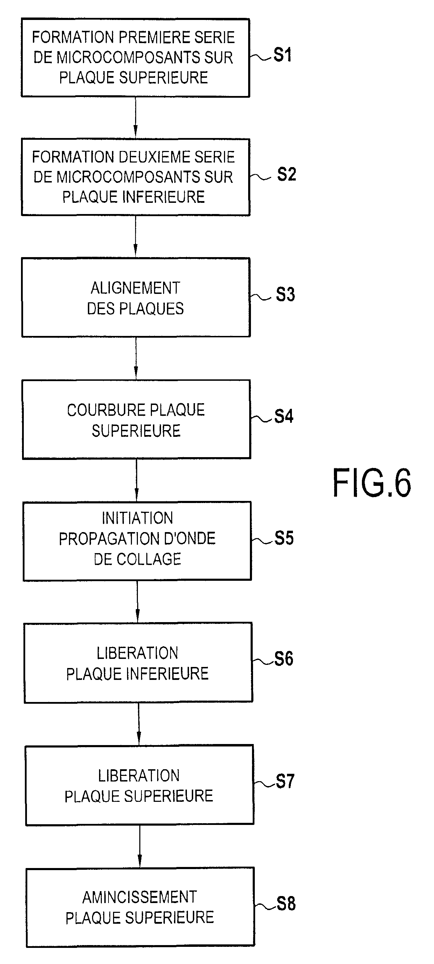

On décrit maintenant en relation avec les figure 5A à 5G et 6 un exemple de réalisation d'une structure tridimensionnelle par transfert d'une couche de microcomposants formée sur une première plaque 100 sur une deuxième plaque 200 mettant en oeuvre un procédé de collage avec compensation du désalignement radial conformément à un mode de réalisation de l'invention. Les plaques peuvent notamment avoir des diamètres de 150 mm, 200 mm et 300 mm.

La réalisation de la structure tridimensionnelle débute par la formation d'une première série de microcomposants 110 à la surface de la première plaque 100 (figure 5A, étape S1) et d'une deuxième série de microcomposants 210 à la surface de la deuxième plaque 200 (figure 5B, étape S2). Les microcomposants 110 et 210 peuvent être des composants entiers et/ou seulement une partie de ceux-ci. Dans l'exemple décrit ici, la première plaque 100 est une plaque de 300 mm de diamètre de type SOI (Silicium sur Isolant) comprenant une couche de silicium 103 sur un support 101 également en silicium, une couche d'oxyde enterrée 102, par exemple en $SiO_2$, étant disposée entre la couche et le support en silicium. La plaque 100 peut être également constituée d'une structure multicouche d'un autre type ou d'une structure monocouche.

La deuxième plaque 200 est une plaque en silicium de 300 mm de diamètre.

Les microcomposants 110 et 210 sont formés par photolithographie au moyen d'un masque permettant de définir les zones de formation de motifs correspondant aux microcomposants à réaliser.

Les microcomposants 110 et 210 sont destinés à coopérer entre eux, par exemple pour former des composants finis par la réunion de microcomposants 110 et 210 deux à deux constituant chacun une partie du composant à réaliser ou pour former des circuits par interconnexion de microcomposants 110 et 210 correspondants. Il est donc important de pouvoir assurer un bon alignement entre les microcomposants 110 et 210 après collage des plaques.

Conformément à l'invention, on utilise une machine de collage qui, lors du collage, impose une courbure de collage $K_B$ à l'une des plaques tout en permettant à l'autre plaque de se conformer à la courbure imposée par propagation de l'onde de collage entre les deux plaques. Cette opération permet d'obtenir une courbure post collage cible $K_{Fc}$ qui introduit entre les deux plaques le désalignement radial de compensation $D_{Rc}$ qui va compenser le désalignement radial initial $D_{Ri}$ présent entre les deux plaques et induit (dilatations radiales différentielles entre les plaques) lors des différentes étapes de traitement réalisées préalablement sur chacune des plaques avant leur collage (lithographie, dépôt de couche, traitements thermiques, etc.).

Comme illustré sur la figure 5C, l'opération de collage est réalisée avec une machine ou appareil de collage 300 qui comprend un premier plateau support 310 présentant une surface de maintien 311 destinée à maintenir la première plaque 100 en regard de la deuxième plaque 200 qui est maintenue sur la surface de maintien 321 d'un deuxième plateau support 320 de la machine 300. Les plateaux supports 310 et 320 sont tous les deux équipés de moyens de maintien (non représenté sur la figure 5C), tels des moyens de maintien électrostatiques ou par succion. Les premier et second plateaux supports 310 et 320 sont chacun mobiles suivant des directions de déplacement $d_{px}$ et $d_{py}$ qui permettent, d'une part, de positionner les plaques l'une en face de l'autre en compensant les erreurs de désalignement en rotation et en translation et, d'autre par, de rapprocher ou d'écarter les surfaces de maintien 311 et 321 respectivement des premier et second plateaux supports 310 et 320. A cet effet, chaque plateau support est, par exemple, monté sur un actionneur (non représenté sur la figure 5C) qui est commandé par la machine de collage afin d'ajuster la distance entre les deux supports suivant la direction $d_P$.

Au début du collage, les deux plaques 100 et 200 sont chacune maintenues plaquées sur les surfaces de maintien de leur plateau support respectif (figure 5C, étape S3).

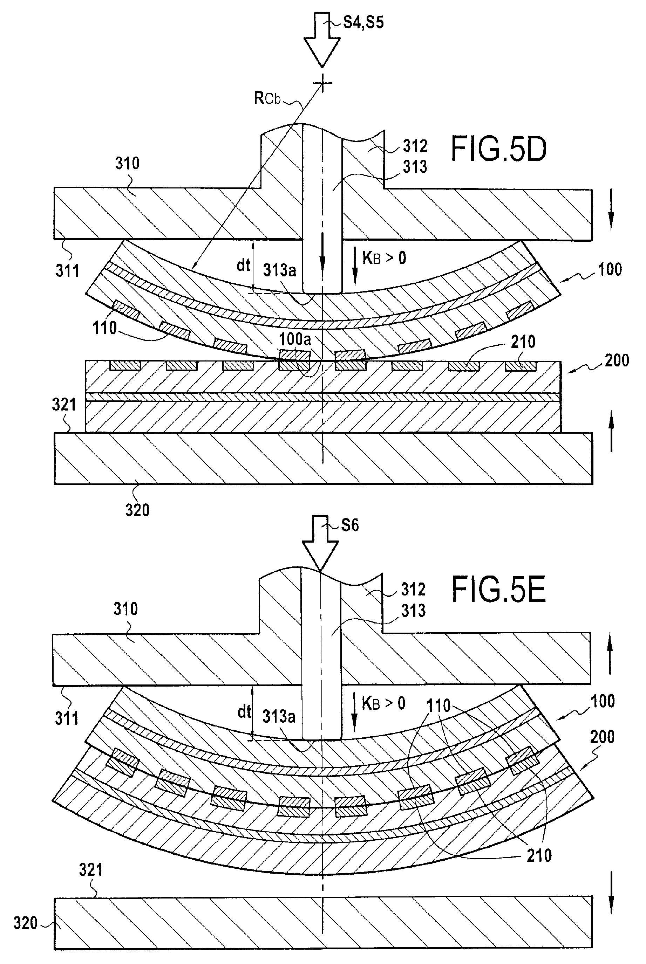

Ensuite, conformément à l'invention, on impose à la première plaque 100 (ou alternativement à la deuxième plaque) une courbure correspondant à la courbure de collage $K_B$ qui a été calculée au moyen de la formule (6) donnée plus haut et qui permet d'obtenir la courbure post collage cible $K_{Fc}$ déterminée préalablement afin d'induire un désalignement radial de compensation $D_{Rc}$ comme décrit ci-avant (figure 5D, étape S4).

A cet effet, le premier plateau support 310 comprend un vérin ou actionneur linéaire 312 muni d'une tige 313 qui, lorsque le vérin est actionné, s'étend au-delà de la surface de maintien 311 du plateau 310 sur laquelle est plaquée la première plaque 100. Comme illustré sur la figure 5D, dans ce cas, l'extrémité libre 313a de la tige 313 pousse sur la première plaque, ce qui permet d'imposer à cette dernière une courbure de collage déterminée. Lors de l'actionnement du vérin 312, la force d'attraction des moyens de maintien du plateau support 310, à savoir la force de succion ou la force électrostatique, peut être contrôlée par la machine de collage de manière à être diminuée, voire annulée, au niveau d'une zone centrale concentrique délimitée sur la surface de maintien 311 du plateau 310 de manière à réduire les contraintes sur la plaque lors de sa courbure par la tige 313.

La machine de collage 300 contrôle la distance dt sur laquelle la tige 313 se projette au-delà de la surface de maintien 311, cette distance dt étant déterminée en fonction de la courbure de collage $K_B$ à imposer aux plaques. Plus précisément, le vérin 312 est équipé d'une servocommande (non représenté) qui contrôle la position linéaire de la tige 313 en fonction d'une position de consigne définie par la machine de collage 300.

La machine de collage 300 est équipée de moyens de traitement, tels qu'un microprocesseur programmable, qui sont aptes à calculer la courbure de collage $K_B$ ou un rayon de courbure équivalent à la courbure de collage $K_B$ dans le cas de l'utilisation d'un vérin comme dans la machine 300 décrite ici. Plus précisément, les courbures initiales $K_1$ et $K_2$ respectivement des plaques 100 et 200 ainsi que la courbure post collage cible $K_{Fc}$ sont entrées dans la machine de collage, les moyens de traitement de la machine de collage calculant alors la courbure de collage $K_B$ à imposer en utilisant la formule (6) donnée ci-avant et inverse cette valeur pour obtenir le rayon de courbure cible correspondant $R_{cb}$ ($R_{cb}=1/K_B$).

Le paramètre final à définir qui doit être envoyé à la servocommande du vérin 312 est le bow $\Delta z$ correspondant au rayon de courbure $R_{cb}$ car, comme indiqué précédemment, le bow d'une plaque ou wafer correspond à la distance, prise eu centre de la plaque, entre un plan de référence, ici la surface de maintien 311 et la surface de la plaque, ici la surface de la plaque en regard de la surface de maintien 311. Le bow $\Delta z$ correspond à la distance dt sur laquelle doit s'étendre la tige 313 lors de l'imposition de la courbure de collage.

Le calcul du bow cible $\Delta zc$ en fonction du rayon de courbure cible $R_{cb}$ peut être calculé avec la formule suivante:

$$\Delta zc = R_{cb} - \sqrt{(R_{cb}^2 - (D/2)^2)} \qquad (7)$$

Où D est le diamètre de la plaque à courber.

Une fois calculée, la valeur numérique du bow cible $\Delta zc$ est transmise à la servocommande du vérin 312 qui actionne la tige pour la positionner à la distance dt équivalente (dt= $\Delta zc$).

Lorsque la courbure de collage $K_B$ est appliquée à la première plaque 100, on rapproche les plateaux supports 310 et 320 l'un de l'autre afin que la portion la plus avancée 100a (sommet) de la plaque 100 soit délicatement placée en contact avec la surface exposée de la deuxième plaque 200 et initier ainsi la propagation d'une onde de collage (figure 5D, étape S5). Les moyens de maintien de la deuxième plaque 200 sur son plateau support 320 ont été désactivés avant ou lors de la mise en contact des deux plaques afin de permettre à la deuxième plaque 200 de se conformer à la déformation imposée (courbure $K_B$) à la première plaque 100 lors du collage.

Alternativement, on peut placer les deux plaques à une distance $\Delta zc$ l'une de l'autre et ensuite déformer l'une des deux plaques jusqu'à mettre en contact intime les surfaces par actionnement de la tige 313 sur une distance dt= $\Delta zc$. On assure ainsi simultanément l'imposition de la courbure de collage $K_B$ et l'initiation de la propagation de l'onde de collage. Dans ce cas encore, la plaque qui n'est pas déformée à la courbure de collage prédéfinie doit être libre de se conformer à la courbure de collage imposée à l'autre plaque lors de la propagation de l'onde de collage.

Le collage par adhésion moléculaire est une technique bien connue en soi. Pour rappel, le principe du collage par adhésion moléculaire est basé sur la mise en contact direct de deux surfaces, c'est-à-dire sans l'utilisation d'un matériau spécifique (colle, cire, brasure, etc.). Une telle opération nécessite que les surfaces à coller soient suffisamment lisses, exemptes de particules ou de contamination, et qu'elles soient suffisamment rapprochées pour permettre d'initier un contact, typiquement à une distance inférieure à quelques nanomètres. Dans ce cas, les forces attractives entre les deux surfaces sont assez élevées pour provoquer la propagation d'une onde de collage qui aboutit à l'adhérence moléculaire (collage induit par l'ensemble des forces attractives (forces de Van Der Waals) d'interaction électronique entre atomes ou molécules des deux surfaces à coller).

Une fois la propagation de l'onde collage initiée, la deuxième plaque 200, alors relâchée de son plateau support 320, se conforme à la courbure imposée à la première plaque 100 lors de la progression de l'onde de collage (figure 5E, étape S6).

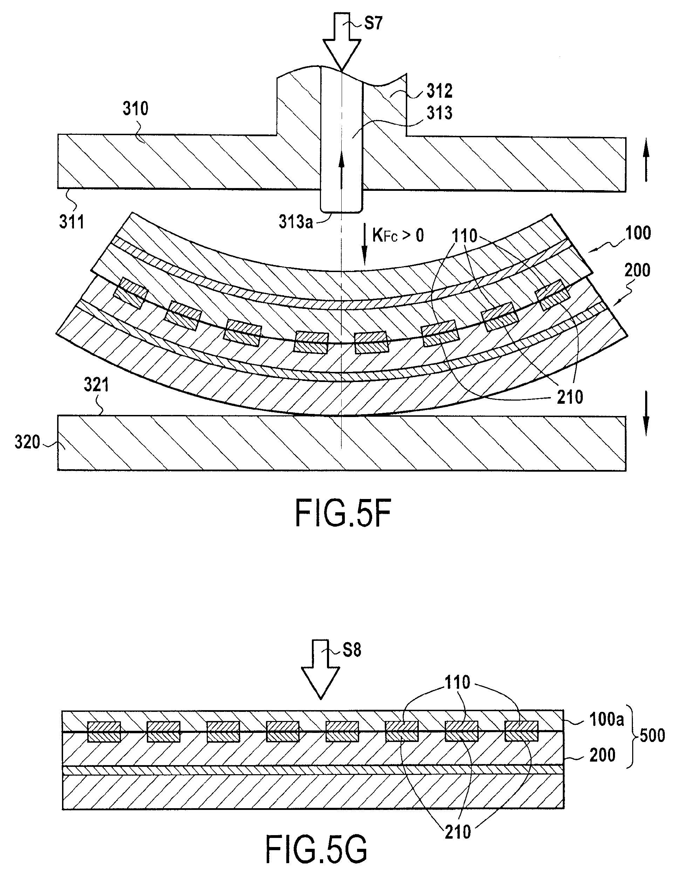

Lorsque les deux plaques sont complètement collées, la première plaque 100 est totalement libérée de son support (figure 5F, étape S7). On obtient alors une structure tridimensionnelle 400 qui présente la courbure cible $K_{Fc}$ définie préalablement.

Le désalignement initial existant entre les deux plaques 100 et 200 a ainsi pu être compensé par l'application d'une courbure de collage prédéterminée. A l'issu du collage, les microcomposants 110 demeurent correctement alignés avec les microcomposants 210 malgré le désalignement radial présent initialement avant collage.

La courbe de la figure 7 correspond à des mesures réalisées sur deux plaques de 300 mm de diamètre et de 775 µm d'épaisseur, comportant chacune deux niveaux de métaux et une couche de collage composée d'un oxyde déposé de type TEOS et préparée. La figure 7 montre l'évolution du désalignement radial en fonction de la courbure post collage $K_F$ des plaques. On constate que, pour une courbure post collage $K_F$ d'environ 0.005 m$^{-1}$, correspondant à un bow d'environ 55 µm, le désalignement radial initial a été totalement compensé. Cette courbe montre bien qu'il est possible, en ajustant la courbure post collage, de créer une composante de désalignement radial supplémentaire qui permet de compenser celle du désalignement radial initial présent entre les plaques.

Après le collage, la structure 400 peut être soumise à un traitement thermique modéré (inférieur à 500°C) de manière à augmenter l'énergie de collage entre les deux plaques et permettre l'amincissement ultérieur de l'une d'entre elle.

Tel que représentée sur la figure 5G, la première plaque 100 est amincie afin de retirer une portion de matière présente au-dessus de la couche de microcomposants 110 (étape S8). Le plaque 100 peut être amincie notamment par polissage mécano-chimique (CMP), par gravure chimique, ou par clivage ou fracture le long d'un plan de fragilisation formé préalablement dans le substrat, par exemple, par implantation atomique. Dans le cas où la première plaque est un substrat de type SOI comme c'est le cas ici, on peut utiliser avantageusement la couche isolante enterrée comme couche d'arrêt de gravure chimique pour délimiter l'épaisseur de la couche 100a restante. Alternativement, si le substrat initial est en matériau massif, des plots profonds, par exemple des plots en matériau métallique régulièrement espacés à la surface du substrat, peuvent être préalablement formés dans celui-ci lors de la formation des composants afin de stopper l'amincissement mécanique (polissage).

On obtient alors une structure tridimensionnelle 500 formée de la deuxième plaque 200 et d'une couche 100a correspondant à la portion restante de la première plaque 100.

Selon une variante de mise en oeuvre, après formation des microcomposants, on peut déposer sur la surface de la première plaque et/ou inférieure une couche d'oxyde, par exemple en SiO$_2$, en vue de la préparation au collage. Cette ou ces couches d'oxyde peuvent être en outre préparées en formant dans ces dernières des plots métalliques, par exemple en cuivre, en contact avec tout ou partie des microcomposants afin de pouvoir mettre en contact des microcomposants d'une plaque avec ceux de l'autre plaque.

Les faces de collage des plaques peuvent en outre être traitées. Les traitements mis en oeuvre pour la préparation de surface varient selon l'énergie de collage que l'on souhaite obtenir. Si l'on souhaite obtenir une énergie collage standard, c'est-à-dire relativement faible, la surface peut être préparée en réalisant un polissage mécano-chimique suivi d'un nettoyage. Autrement, si l'on souhaite obtenir une énergie de collage importante entre les deux substrats, la préparation de la surface comprend un nettoyage de type RCA (à savoir la combinaison d'un bain SC1 (NH$_4$OH, H$_2$O$_2$, H$_2$O) adapté au retrait des particules et des hydrocarbures et d'un bain SC2 (HCl, H$_2$O$_2$, H$_2$O) adapté au retrait des contaminants métalliques), une activation de surface par plasma, un nettoyage supplémentaire suivi d'un brossage.

Le collage est réalisé de préférence sous une température contrôlée afin de réduire la différence de température entre les deux plaques.

L'imposition de la courbure de collage peut être également réalisé avec une machine de collage comprenant une membrane interposée entre la première plaque et le support de maintien de cette dernière, la membrane présentant une courbure correspondant à ladite courbure de collage prédéfinie, ou avec une machine de collage comprenant un support de maintien pour la première plaque présentant une courbure correspondant à ladite courbure de collage prédéfinie, le support de maintien pouvant notamment être déformable et piloté par la machine pour se conformer à la courbure de collage calculée précédemment par cette dernière. La mise en contact de la deuxième plaque avec la première plaque et la libération de la deuxième plaque avant l'initiation de la propagation d'une onde de collage étant réalisées comme décrit ci-avant.

Grâce au procédé de collage avec compensation du désalignement radial de l'invention, la première plaque 100 (Top) a pu être collée sur la deuxième plaque 200 (Base) sans décalages significatifs entre les microcomposants 110 et 210. On peut ainsi limiter les désalignements radiaux à des valeurs négligeables de manière homogène sur toute la surface des plaques. Les microcomposants 110 et 210, même de tailles très réduites (par exemple < 1 $\mu$m), peuvent alors être formés facilement en alignement les uns avec les autres. Cela permet, par exemple, d'interconnecter entre eux les microcomposants, par l'intermédiaire de connections métalliques, en minimisant les risques de mauvaise interconnexion.

**Revendications**

1.  Procédé de collage par adhésion moléculaire d'une première plaque (100) sur une deuxième plaque (200), lesdites plaques présentant entre elles un désalignement radial initial ($D_R$), ledit procédé comprenant au moins une étape de mise en contact des deux plaques (100, 200) de manière à initier la propagation d'une onde de collage entre les deux plaques,
    **caractérisé en ce qu'**on impose une courbure de collage prédéfinie ($K_B$) en fonction du désalignement radial initial ($D_R$) à l'une au moins des deux plaques lors de l'étape de mise en contact.

2.  Procédé selon la revendication 1, **caractérisé en ce que** la deuxième plaque (200) est libre de se conformer à la courbure de collage prédéfinie ($K_B$) imposée à la première plaque (100) lors de la propagation de l'onde de collage.

3.  Procédé selon la revendication 1 ou 2, **caractérisé en ce que** les plaques (100, 200) sont des plaquettes circulaires de silicium d'un diamètre de 300 mm et comportant chacune des microcomposants.

4.  Procédé selon l'une quelconque des revendications 1 à 3, **caractérisé en ce que**, avant le collage desdites plaques (100, 200), le procédé comprend les étapes suivantes:

    - mesure du désalignement radial initial ($D_R$) entre les deux plaques à compenser,
    - mesure de la courbure ($K_1$; $K_2$) de chaque plaque (100; 200) avant collage,
    - détermination d'un désalignement radial de compensation ($D_{Rc}$) du désalignement radial initial ($D_R$) entre les deux plaques (100, 200),
    - calcul d'une courbure post collage ($K_{Fc}$) apte à générer entre les deux plaques ledit désalignement radial de compensation ($D_{Rc}$),
    - calcul de la courbure de collage prédéfinie ($K_B$) en fonction de la courbure post collage ($K_{Fc}$) calculée.

5.  Procédé selon la revendication 4, **caractérisé en ce que** le la courbure post collage est calculée avec la formule suivante:

$$K_{Fc} = D_{Rc}/(h.R)$$

où $K_{Fc}$ est la courbure post collage, $D_{Rc}$ est le désalignement radial de compensation, h est l'épaisseur de la première plaque et R est la distance du centre de la plaque au point de mesure du désalignement radial.

6.  Procédé selon la revendication 4 ou 5, **caractérisé en ce que** la courbure de collage prédéfinie est calculée avec la formule suivante:

$$K_B = (8K_{Fc} - (K_1+K_2))/6$$

où $K_B$ est la courbure de collage prédéfinie, $K_1$ la courbure initiale de la première plaque, $K_2$ la courbure initiale de la deuxième plaque et $K_{Fc}$ la courbure post collage.

7.  Procédé selon l'une quelconque des revendications 1 à 6, **caractérisé en ce qu'**il comprend les étapes suivantes:

    - maintien de la première plaque (100) et de la deuxième plaque (200) en regard l'une de l'autre par respectivement un premier support de maintien (310) et un second support de maintien (320), ledit premier support imposant à la première plaque ladite courbure de collage prédéfinie,
- mise en contact desdites plaques (100, 200) pour initier la propagation d'une onde de collage entre lesdites plaques,
- libération de la deuxième plaque (200) du second support de maintien (320) avant ou pendant la mise en contact avec la première plaque (100) de manière à ce que ladite deuxième plaque se conforme à la courbure de collage imposée à la première plaque lors de la propagation de l'onde de collage.

8. Procédé selon la revendication 7, **caractérisé en ce que** ladite courbure de collage prédéfinie ($K_B$) est imposée à la première plaque (100) par actionnement d'un vérin (312) monté sur le premier support de maintien.

9. Procédé selon la revendication 7, **caractérisé en ce que** ladite courbure de collage prédéfinie ($K_B$) est imposée à la première plaque (100) par une membrane interposée entre la première plaque (100) et le premier support de maintien (310), ladite membrane présentant une courbure correspondant à ladite courbure de collage prédéfinie.

10. Procédé selon la revendication 7, **caractérisé en ce que** ladite courbure de collage prédéfinie ($K_B$) est imposée à la première plaque (100) par le premier support de maintien (310), ledit premier support de maintien présentant une courbure correspondant à ladite courbure de collage prédéfinie.

11. Procédé selon l'une quelconque des revendications 1 à 10, **caractérisé en ce que** lesdites plaques (100, 200) comprennent chacune des microcomposants (110; 210) sur leur face de collage respective, au moins une partie des microcomposants (110) d'une (100) des plaques étant destinée à être alignée avec au moins une partie des microcomposants (210) de l'autre (200) plaque.

12. Appareil de collage (300) par adhésion moléculaire d'une première plaque (100) sur une deuxième plaque (200), lesdites plaques présentant entre elles un désalignement radial initial ($D_R$), l'appareil comprenant des premier et second supports de maintien (310, 320) pour maintenir respectivement la première plaque (100) et la deuxième plaque (200), **caractérisé en ce que** ledit premier support de maintien comprend des moyens pour imposer à ladite première plaque une courbure de collage prédéfinie ($K_B$) en fonction du désalignement radial initial, l'appareil commandant le deuxième support de maintien (320) pour libérer la deuxième plaque (200) dudit deuxième support avant ou pendant la mise en contact avec la première plaque (100) de manière à ce que ladite deuxième plaque (200) se conforme à la courbure de collage imposée à la première plaque (100) lors de la propagation d'une onde de collage.

13. Appareil selon la revendication 12, **caractérisé en ce qu'**il comprend des moyens de traitement pour calculer la courbure de collage prédéfinie ($K_B$) en fonction du désalignement radial initial ou un rayon de courbure correspondant à ladite courbure de collage prédéfinie en fonction du désalignement radial initial ($D_R$).

14. Appareil selon la revendication 13, **caractérisé en ce que** ledit premier support de maintien (310) comprend en outre un vérin (312) apte à imposer ladite courbure de collage prédéfinie ($K_B$) à la première plaque (100), le vérin étant piloté selon un rayon de courbure correspondant à ladite courbure de collage prédéfinie ($K_B$), l'appareil commandant le deuxième support de maintien (320) pour libérer la deuxième plaque (200) dudit second support après mise en contact avec la première plaque (100) de manière à ce que ladite deuxième plaque (200) se conforme à la courbure de collage imposée à la première plaque lors de la propagation d'une onde de collage.

15. Appareil selon la revendication 12, **caractérisé en ce que** ledit premier support de maintien présente une courbure correspondant à ladite courbure de collage prédéfinie ou **en ce que** ledit appareil comprend en outre une membrane interposée entre la première plaque (100) et le premier support de maintien, ladite membrane présentant une courbure correspondant à ladite courbure de collage prédéfinie ($K_B$).

FIG.1A

FIG.1B

FIG.2

FIG.3

$K_1 < 0$

50

$K_2 > 0$

60

# FIG.4A

$K_B < 0$

50

60

# FIG.4B

$K_F < 0$

50

60

# FIG.4C

FIG.5A

FIG.5B

FIG.5C

FIG.5D

FIG.5E

FIG.5F

FIG.5G

```
┌──────────────────────────┐
│  FORMATION PREMIERE SERIE │
│  DE MICROCOMPOSANTS SUR   │──S1
│    PLAQUE SUPERIEURE      │
└──────────────────────────┘
             │
             ▼
┌──────────────────────────┐
│  FORMATION DEUXIEME SERIE │
│  DE MICROCOMPOSANTS SUR   │──S2
│    PLAQUE INFERIEURE      │
└──────────────────────────┘
             │
             ▼
┌──────────────────────────┐
│      ALIGNEMENT           │
│      DES PLAQUES          │──S3
└──────────────────────────┘
             │
             ▼
┌──────────────────────────┐
│    COURBURE PLAQUE        │
│      SUPERIEURE           │──S4
└──────────────────────────┘
             │
             ▼
┌──────────────────────────┐
│      INITIATION           │
│  PROPAGATION D'ONDE       │──S5
│    DE COLLAGE             │
└──────────────────────────┘
             │
             ▼
┌──────────────────────────┐
│      LIBERATION           │
│   PLAQUE INFERIEURE       │──S6
└──────────────────────────┘
             │
             ▼
┌──────────────────────────┐
│      LIBERATION           │
│   PLAQUE SUPERIEURE       │──S7
└──────────────────────────┘
             │
             ▼
┌──────────────────────────┐
│    AMINCISSEMENT          │
│   PLAQUE SUPERIEURE       │──S8
└──────────────────────────┘
```

FIG.6

FIG.7

**EP 2 405 465 A1**

| | Europäisches Patentamt<br>European Patent Office<br>Office européen des brevets | **RAPPORT DE RECHERCHE EUROPEENNE** | Numéro de la demande<br>EP 11 16 8039 |
|---|---|---|---|

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2009/280595 A1 (BROEKAART MARCEL [FR] ET AL) 12 novembre 2009 (2009-11-12)<br>* alinéa [0015] - alinéa [0019] *<br>* alinéa [0033] - alinéa [0037]; figures 1a-1e,3-5 *<br>----- | 1-11 | INV.<br>H01L21/18 |
| X | US 4 752 180 A (YOSHIKAWA KIYOSHI [JP]) 21 juin 1988 (1988-06-21) | 12-15 | |
| A | * revendications 5-13; figures 4a-4c *<br>----- | 1-11 | |
| A | US 2007/087531 A1 (KIRK HARRY R [US] ET AL KIRK HARRY R [US] ET AL) 19 avril 2007 (2007-04-19)<br>* alinéa [0011] - alinéa [0043]; figures 1-8 * | 1-15 | |
| A | WO 2006/038030 A2 (APPLIED MICROENGINEERING LTD [GB]; ROGERS TONY [GB]) 13 avril 2006 (2006-04-13)<br>* alinéa [0019] - alinéa [0022]; figures 1-4 *<br>----- | 12-15 | |

DOMAINES TECHNIQUES RECHERCHES (IPC)

H01L

Le présent rapport a été établi pour toutes les revendications

| Lieu de la recherche | Date d'achèvement de la recherche | Examinateur |
|---|---|---|
| La Haye | 10 août 2011 | Hedouin, Mathias |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**          EP 11 16 8039

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-08-2011

| Document brevet cité au rapport de recherche | | Date de publication | Membre(s) de la famille de brevet(s) | | Date de publication |
|---|---|---|---|---|---|
| US 2009280595 | A1 | 12-11-2009 | CN | 102017074 A | 13-04-2011 |
| | | | EP | 2272084 A2 | 12-01-2011 |
| | | | WO | 2009135800 A2 | 12-11-2009 |
| | | | FR | 2931014 A1 | 13-11-2009 |
| | | | JP | 2011519157 A | 30-06-2011 |
| | | | KR | 20100123917 A | 25-11-2010 |
| US 4752180 | A | 21-06-1988 | AUCUN | | |
| US 2007087531 | A1 | 19-04-2007 | AUCUN | | |
| WO 2006038030 | A2 | 13-04-2006 | EP | 1815500 A2 | 08-08-2007 |
| | | | US | 2007287264 A1 | 13-12-2007 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **T. TURNER et al.** Mechanics of wafer bonding: Effect of clamping. *Journal of Applied Physics,* 01 Janvier 2004, vol. 95 (1